(19)

Europäisches
Patentamt
European
Patent Office
Office européen
des brevets

(11) **EP 3 372 727 A1**

(12) **EUROPEAN PATENT APPLICATION**
published in accordance with Art. 153(4) EPC

(43) Date of publication:
**12.09.2018 Bulletin 2018/37**

(51) Int Cl.:
*D06M 11/83* [(2006.01)]     *C03C 25/10* [(2018.01)]
*D06M 101/00* [(2006.01)]

(21) Application number: **16862040.9**

(22) Date of filing: **31.10.2016**

(86) International application number:
**PCT/JP2016/082274**

(87) International publication number:
**WO 2017/077980 (11.05.2017 Gazette 2017/19)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **02.11.2015   JP 2015215933
13.01.2016   JP 2016004554
02.06.2016   JP 2016110810**

(71) Applicant: **Central Glass Company, Limited
Yamaguchi 755-0001 (JP)**

(72) Inventors:
• **ASAKAWA, Yuya**
  **Matsusaka-shi**
  **Mie 515-0001 (JP)**
• **SAITO, Masanori**
  **Matsusaka-shi**
  **Mie 515-0001 (JP)**

(74) Representative: **Vossius & Partner
Patentanwälte Rechtsanwälte mbB
Siebertstrasse 3
81675 München (DE)**

(54) **ELECTROMAGNETIC SHIELDING METAL-COATED GLASS FIBER FILLER, METHOD FOR MANUFACTURING ELECTROMAGNETIC SHIELDING METAL-COATED GLASS FIBER FILLER, AND ELECTROMAGNETIC SHIELDING RESIN ARTICLE**

(57)     The present invention provides an electromagnetic shielding metal-coated glass fiber filler to be used as a composite with resin, the glass fiber filler including: glass fiber; and a metal coating in the longitudinal direction of the glass fiber, wherein the metal coating is made of an alloy containing a first metal consisting of zinc and a second metal consisting of a metal having a lower oxidation-reduction potential than zinc (i.e., being more easily oxidized than zinc), the second metal is at least one selected from the group consisting of barium, strontium, calcium, magnesium, beryllium, aluminum, titanium, zirconium, manganese, and tantalum, and the alloy contains the first metal in an amount of 50% by mass or more.

FIG.1
(a)        (b)

EP 3 372 727 A1

## Description

TECHNICAL FIELD

The present invention relates to an electromagnetic shielding metal-coated glass fiber filler to be used as a composite with resin, a method for manufacturing the filler, and an electromagnetic shielding resin article including the filler.

BACKGROUND ART

Metal articles for housings of electronic devices or the like have been increasingly replaced by resin articles. This trend has created a demand for techniques to block electromagnetic waves with resin articles as is the case with metal materials. As a method for imparting electromagnetic shielding characteristics to resin materials, a method for mixing a resin article with a conductive filler has been suggested. For example, Patent Literatures 1 and 2 each suggest a glass fiber that is entirely or partially coated with aluminum in the longitudinal direction thereof, to be used as an electromagnetic shielding glass fiber filler. Patent Literatures 3 to 5 each disclose a conductive resin article including a fiber filler. Examples of fiber include glass fiber coated with a metal such as zinc or zinc alloy by a method such as hot-dipping, electroless plating, vacuum deposition, or sputtering.

CITATION LIST

- Patent Literature

Patent Literature 1: JP S61-29083 B
Patent Literature 2: JP S60-113996 A
Patent Literature 3: JP 2012-236944 A
Patent Literature 4: JP S63-20270 B
Patent Literature 5: JP H04-19720 B

SUMMARY OF INVENTION

- Technical Problem

An oxidized surface of aluminum has high resistance. The oxidization results in high electrical resistance at a contact portion between aluminum surfaces. This portion interferes with conductivity, preventing an increase in the conductivity of resin articles containing an aluminum-coated glass fiber filler, despite the filler content. Thus, in the case of use of conventional aluminum-coated glass fiber as filler applications, the filler content should be high or the length of the fiber should be long in order to ensure the conductivity of resin articles. These limitations put restrictions on the material design of resin articles (see Patent Literatures 1 and 2). Patent Literatures 3 to 5 each suggest a metal coating having good conductivity, but a further improvement is necessary for practical application of metal-coated glass fiber.
In view of the situation described above, the present invention focused on zinc that is promising in improving the conductivity at a contact portion between metal coating surfaces (hereinafter referred to as "contact conductivity") . The present invention aims to provide an electromagnetic shielding metal-coated glass fiber filler having good contact conductivity, using a metal coating with a composition containing zinc as a basic component. The present invention also aims to provide a method for manufacturing the filler, and an electromagnetic shielding resin article including the filler.

- Solution to Problem

The present invention provides an electromagnetic shielding metal-coated glass fiber filler to be used as a composite with resin, the glass fiber filler including: glass fiber; and a metal coating in the longitudinal direction of the glass fiber, wherein the metal coating is made of an alloy containing a first metal consisting of zinc and a second metal consisting of a metal having a lower oxidation-reduction potential than zinc (i.e. , more easily oxidized than zinc), the second metal is at least one selected from the group consisting of barium, strontium, calcium, magnesium, beryllium, aluminum, titanium, zirconium, manganese, and tantalum, and the alloy contains the first metal in an amount of 50% by mass or more.
In the electromagnetic shielding metal-coated glass fiber filler of the present invention, the metal coating is made of an alloy containing the first metal consisting of zinc in an amount of 50% by mass or more. Thus, the interference with the conductivity between the fillers is reduced, improving the contact conductivity. Thus, when used as a composite with resin, the filler can impart electromagnetic shielding effect to the resin.

The melting temperature of zinc is lower than the softening point of the glass fiber. Thus, as is the case with aluminum-coated glass fiber, it is expectedly possible to form a metal coating on the surface of the glass fiber by bringing the glass fiber into contact with a molten metal while spinning the glass fiber. When zinc is melted at a temperature close to its melting point (e.g. , 500°C) and the glass fiber is brought into contact with a molten metal, a zinc-coated glass fiber can be obtained. Yet, in the case of conventional zinc-coated glass fiber, the adhesion is low between the glass fiber and the metal coating, leaving a room for improvement. It is possible to improve the adhesion by melting zinc at a higher temperature (e.g., 700°C) and bringing the glass fiber into contact with a molten metal. Yet, as a result of studies, the present inventors found that melting zinc at 700°C promotes oxidation of a molten metal surface layer, easily causing problems, such as generation of sludge on the molten metal surface layer, and making it difficult to efficiently produce metal-coated glass fiber. As described above, in the case of zinc-coated glass fiber, the adhesion between the metal coating and the glass fiber and the productivity of the zinc-coated glass fiber depend on the degree of the melting temperature of zinc.

In contrast, the electromagnetic shielding metal-coated glass fiber filler of the present invention has improved adhesion between the metal coating and the glass fiber because the metal coating contains the first metal consisting of zinc and the second metal consisting of a metal having a lower oxidation-reduction potential than zinc. Presumably, the improvement in adhesion is associated with an improvement in affinity between the metal coating and oxygen in silicon oxide on the surface of the glass fiber resulting from the presence of the metal having a lower oxidation-reduction potential than zinc in the metal coating. As described above, the filler coated with an alloy containing zinc as the first metal as a main component and aluminum, titanium and the like as the second metal has good contact conductivity and good adhesion between the metal coating and the glass fiber.

The method for manufacturing an electromagnetic shielding metal-coated glass fiber filler of the present invention is a method for producing an electromagnetic shielding metal-coated glass fiber filler to be used as a composite with resin, the method including: melting a metal material in a metal melting furnace to form molten metal; forming a molten metal droplet by discharging a molten metal from an orifice provided to the metal melting furnace for discharging the molten metal to the outside; bringing glass fiber being drawn out of a bushing nozzle of a glass melting furnace into contact with the droplet; and cutting metal-coated glass fiber, wherein the metal material contains a first metal consisting of zinc and a second metal consisting of a metal having a lower oxidation-reduction potential than zinc, the second metal is at least one selected from the group consisting of barium, strontium, calcium, magnesium, beryllium, aluminum, titanium, zirconium, manganese, and tantalum, and the metal material contains the first metal in an amount of 50% by mass or more.

In the method for manufacturing an electromagnetic shielding metal-coated glass fiber filler of the present invention, the melting temperature of the coating metal is not required to be high, and the method enables efficient production of an electromagnetic shielding metal-coated glass fiber filler.

The electromagnetic shielding resin article of the present invention includes the metal-coated glass fiber filler of the present invention.

- Advantageous Effects of Invention

The electromagnetic shielding metal-coated glass fiber filler of the present invention has good contact conductivity. When used as a composite with resin, the fiber filler can impart electromagnetic shielding effect to the resin.

BRIEF DESCRIPTION OF DRAWINGS

Fig. 1 (a) and Fig. 1(b) each show a schematic perspective view of an exemplary electromagnetic shielding metal-coated glass fiber filler of the present invention.
Fig. 2 shows a schematic explanatory view of a device for producing the electromagnetic shielding metal-coated glass fiber filler of the present invention.
Fig. 3 is an expanded view of an area A shown in Fig. 2.

DESCRIPTION OF EMBODIMENTS

[Electromagnetic shielding metal-coated glass fiber filler]

The following describes examples of the electromagnetic shielding metal-coated glass fiber filler of the present invention (hereinafter also simply referred to as the "fiber filler" or "filler") and the method for producing the filler, with reference to the drawings.

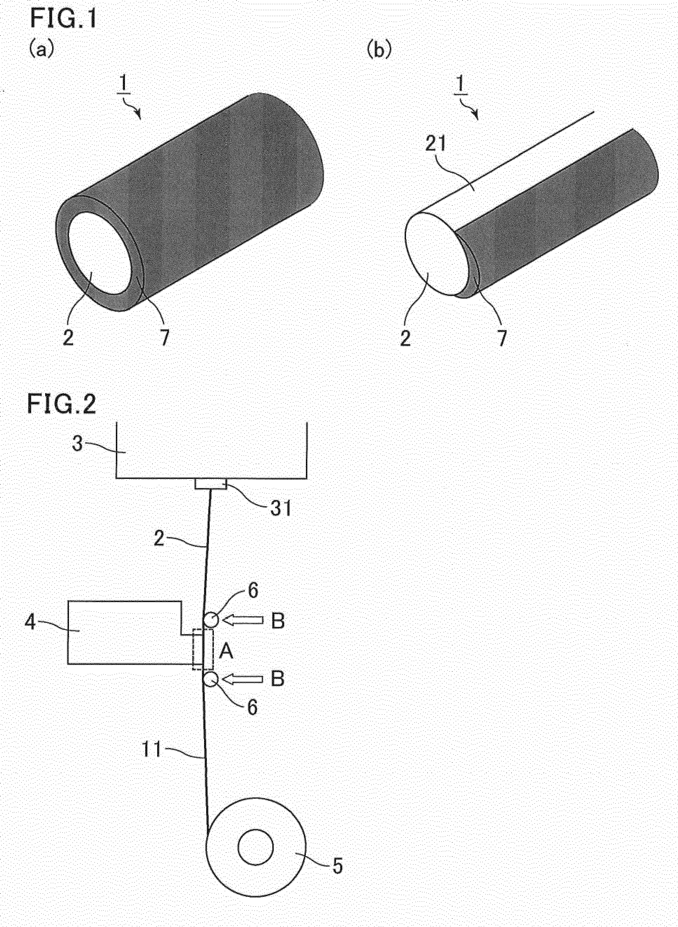

Fig. 1 (a) and Fig. 1 (b) each show a schematic perspective view of an exemplary electromagnetic shielding metal-coated glass fiber filler of the present invention.

A fiber filler 1 includes glass fiber 2 and a metal coating 7 formed on the glass fiber 2 in the longitudinal direction thereof. The metal coating 7 may cover the entire surface of the glass fiber 2 in the longitudinal direction as shown in Fig. 1(a), or may cover a portion, e.g., the half or a quarter of the circumference, of the glass fiber in the longitudinal direction as shown in Fig. 1(b).

When the metal coating 7 covers the entire surface of the glass fiber 2 in the longitudinal direction, the metal coating has a large surface area. Thus, even higher contact conductivity can be achieved.

When the metal coating 7 covers a portion of the glass fiber 2 in the longitudinal direction, a portion without the metal coating 7 is a metal-uncoated surface 21 where the glass fiber 2 is exposed to the surface. In the case where glass fiber is combined with resin into a resin article, it is generally known that forming a silane coupling-treated layer on the glass fiber can improve the adhesion between the glass fiber and the resin, thus improving the strength of the resin article. Thus, forming a silane coupling-treated layer on the metal-uncoated surface 21 can improve the adhesion between the filler 1 and resin, improving the strength of a resin article including the filler and the rein. Meanwhile, since the metal-coated glass fiber filler of the present invention can increase the contact conductivity, it is possible to provide excellent conductivity, despite the presence of the metal-uncoated surface 21. Thus, when the metal coating covers a portion of the glass fiber, it is possible to obtain an electromagnetic shielding resin article having improved strength, with the electromagnetic shielding effect maintained.

In view of these points, the ratio (area ratio) of the metal coating to the entire circumference of the glass fiber is preferably 5% or more. In the case of a structure in which the metal coating covers a portion of the glass fiber, the ratio (area ratio) of the metal coating to the entire circumference of the glass fiber is preferably 90% to 5%, more preferably 80% to 5%. The ratio of the metal coating to the entire circumference of the glass fiber may be 90% to 20%, or 80% to 30%.

<Metal coating>

In the electromagnetic shielding metal-coated glass fiber filler of the present invention, the metal coating is made of an alloy containing zinc as the first metal and a metal having a lower oxidation-reduction potential than zinc as the second metal. Zinc has an oxidation-reduction potential of -0.76 V.

(First metal)

The first metal consists of zinc. The zinc content in the alloy is 50% by mass or more. In the case of a fiber filler containing an alloy having a zinc content of less than 50% by mass, the effect of zinc to improve the contact conductivity will be small or absent, making it difficult to impart sufficient electromagnetic shielding effect to a resin article including such a fiber filler. In view of these points, the zinc content in the alloy is preferably 75% by mass or more, and it may be 85% by mass or more. The upper limit of the zinc content in the alloy is not particularly limited, but the zinc content in the alloy is preferably 99.999% by mass or less, and may be 99.99% by mass or less.

(Second metal)

The second metal consists of a metal having a lower oxidation-reduction potential than zinc. The second metal may be at least one selected from the group consisting of barium (-2.92 V), strontium (-2.89 V), calcium (-2.84 V), magnesium (-2.36 V), beryllium (-1.85 V), aluminum (-1.68 V), titanium (-1.63 V), zirconium (-1.53 V), manganese (-1.18 V), and tantalum (-0.81 V). The numerical values in the parentheses indicate oxidation-reduction potentials.

In particular, when hot-dip coating is performed in an air atmosphere, the second metal is preferably a metal having an oxidation-reduction potential of -2.5 V or higher because a metal a having a higher oxidation-reduction potential is less easily oxidized in air and is more easy to handle. Examples of such metals include at least one selected from the group consisting of magnesium (-2.36 V), beryllium (-1.85 V), aluminum (-1.68 V), titanium (-1.63 V), zirconium (-1.53 V), manganese (-1.18 V), and tantalum (-0.81 V). Examples of more preferred metals among these include at least one selected from the group consisting of aluminum and titanium.

The alloy constituting the metal coating preferably contains the second metal in an amount of 0.01% by mass or more. Surprisingly, even when the second metal is contained in a trace amount, the second metal seems to be capable of improving the adhesion between the metal coating and the glass fiber. In view of such adhesion, the second metal content may be 0.03% by mass or more, or 0.05% by mass or more. The alloy constituting the metal coating preferably contains the second metal in an amount of 30% by mass or less. If the second metal content is 30% by mass or less, sufficient electromagnetic shielding effect seems to be easily provided to a resin article including the fiber filler. In view of this point, the second metal content may be 20% by mass or less, 10% by mass or less, 5% by mass or less, 4% by mass or less, 3% by mass or less, or 1% by mass or less. The alloy constituting the metal coating is preferably substantially formed of the first metal and the second metal. In this case, the alloy may contain inevitable impurities as a third metal.

When the metal coating is made of an alloy containing the first metal and the second metal, the metal coating may cover the entire surface of the glass fiber in the longitudinal direction or a portion of the glass fiber in the longitudinal direction as described above (hereinafter referred to as the first aspect).

Specifically, the electromagnetic shielding metal-coated glass fiber filler according to the first aspect of the present invention is an electromagnetic shielding metal-coated glass fiber filler including: glass fiber; and a metal coating in the longitudinal direction of the glass fiber, wherein the metal coating is made of an alloy containing a first metal and a second metal, and the alloy containing the first metal in an amount of 50% by mass or more. The electromagnetic shielding metal-coated glass fiber filler is used as a composite with resin.

In addition, there may be a case where the metal coating is made of metal zinc. Also in this case, the metal coating may cover the entire surface of the glass fiber in the longitudinal direction or a portion of the glass fiber in the longitudinal direction, as described above (hereinafter referred to as the second aspect).

Specifically, the electromagnetic shielding metal-coated glass fiber filler according to the second aspect of the present invention is an electromagnetic shielding metal-coated glass fiber filler including: glass fiber; and a metal coating in the longitudinal direction of the glass fiber, wherein the metal coating is made of metal zinc, and covers all or a portion of the surface of the glass fiber in the longitudinal direction. The electromagnetic shielding metal-coated glass fiber filler is used as a composite with resin. The metal zinc may contain inevitable impurities.

As used herein, the electromagnetic shielding metal coating fillers according to the first aspect and the second aspect are described as the electromagnetic shielding metal coating filler of the present invention without distinction therebetween. In the description heretofore and hereinafter, a preferred structure according to the first aspect is similarly a preferred structure according to the second aspect, and the "alloy" or the "zinc alloy" may be construed as the "metal zinc".

In the electromagnetic shielding metal-coated glass fiber filler of the present invention, the volume ratio of the glass fiber to the metal coating is preferably 5-95% by volume of the glass fiber to 5-95% by volume of the metal coating. A glass fiber having a volume ratio of less than 5% by volume has a small diameter and thus tends to have poor productivity during the production, A glass fiber having a volume ratio of more than 95% by volume tends to make it difficult to form the metal coating thereon. In view of these points, the volume ratio of the glass fiber is preferably 5 to 95% by volume (5 to 95% by volume of the metal coating), more preferably 10 to 95% by volume (5 to 90% by volume of the metal coating), still more preferably 20 to 95% by volume (5 to 80% by volume of the metal coating) . The volume ratio of the glass fiber may be 10 to 90% by volume (10 to 90% by volume of the metal coating) or 20 to 90% by volume (10 to 80% by volume of the metal coating).

In the electromagnetic shielding metal-coated glass fiber filler of the present invention, the metal coating is preferably formed by hot-dipping.

<Glass fiber>

The glass fiber preferably has a length of 0.01 to 50 mm. If the length of the glass fiber is less than 0.01 mm, even when the metal coating is made of an alloy having a zinc content of 50% by mass or more, it will be difficult to obtain an electromagnetic shielding resin article having good conductivity. In contrast, if the length is more than 50 mm, an electromagnetic shielding resin article will have poor formability. In particular, since the reason for the lower limit is also the factor for efficient production of an electromagnetic shielding resin article including a fiber filler, the length of the glass fiber may also be 0.5 to 50 mm. In view of the reason for the lower limit and the reason for the upper limit, the length of the glass fiber may also be 0.5 to 30 mm, 1 to 30 mm, 1 to 15 mm, 1 to 10 mm, 1 to 5 mm, or 1 to 3 mm.

The glass fiber preferably has a diameter of 1 to 100 $\mu$m. Glass fiber having a diameter of less than 1 $\mu$m has poor productivity during production because such glass fiber easily breaks. In contrast, glass fiber having a diameter of more than 100 $\mu$m has a small surface area per unit weight. As a result, such glass fiber has a small surface area to be coated by an alloy, making it difficult to achieve intended properties. In view of the reason for the lower limit and the reason for the upper limit, the diameter of the glass fiber may be 2 to 50 $\mu$m, 2 to 30 $\mu$m, or 3 to 20 $\mu$m.

The length and the diameter of the glass fiber are preferably in the above ranges, but the filler may inevitably contain fiber outside the above ranges. In such a case, the filler may contain fiber outside the above ranges in an amount up to 1% by mass.

Examples of the composition of the glass fiber include compositions of E-glass, C-glass, S-glass, D-glass, ECR-glass, A-glass, and AR-glass. Of these, the E-glass composition is particularly preferred. Since the E-glass composition contains only a small amount of alkaline components, advantageously, it is less likely to cause alkaline dissolution and does not much affect the resin material.

[Method for producing electromagnetic shielding metal-coated glass fiber filler]

Specific examples of the method for producing an electromagnetic shielding metal-coated glass fiber filler of the present invention are described in detail below with reference to the drawings.

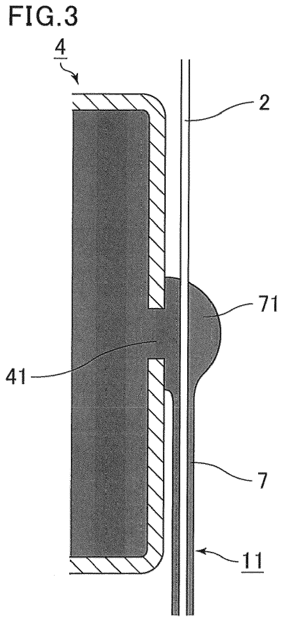

Fig. 2 shows a schematic explanatory view of a device for producing the electromagnetic shielding metal-coated glass fiber filler of the present invention. Fig. 3 is an expanded view of an area A shown in Fig. 2.

As shown in Fig. 2, the glass fiber 2 being drawn out of a bushing nozzle 31 attached to the bottom of a glass melting furnace 3 is wound up by a glass fiber winder 5. A metal melting furnace 4 for forming the metal coating is arranged between the bushing nozzle 31 and the winder 5, and includes an orifice 41 on the side that comes into contact with the glass fiber 2 for discharging molten metal to the outside. The molten metal seeps out of the orifice 41 to form a droplet 71 (see Fig. 3). The glass fiber 2 is pushed toward the metal melting furnace 4 (in the direction of arrow B in Fig. 2) by a pushing machine 6 and is brought into contact with the droplet 71.

<Formation of glass fiber>

The glass fiber 2 is formed by drawing out the glass melt from the bushing nozzle 31 attached to the bottom of the glass melting furnace 3 and winding up the glass melt by the glass fiber winder 5. The bushing nozzle 31 may be made of platinum or a platinum rhodium alloy. The diameter of the bushing nozzle 31 for the glass melt to flow out may be preferably about 1 to 5 mm $\phi$, and is appropriately adjusted according to the desired diameter of the glass fiber. The temperature of the glass melt to be made into fiber varies depending on the glass composition. Yet, in the case of the E-glass composition, the temperature is preferably adjusted such that it is about 1100°C to 1350°C when the E-glass melt passes through the bushing nozzle.

<Metal melting furnace>

The glass fiber 2 is coated with a metal during the time from when it starts being drawn out of the bushing nozzle 31 until it is wound up by the winder 5. The metal material of the metal coating 7 is melted in the metal melting furnace 4 into molten metal in the metal melting furnace 4, and molten metal is discharged from the orifice 41 formed in a wall surface of the metal melting furnace 4. If the orifice 41 is designed to have poor wettability at its peripheral portion with molten metal, the molten metal discharged from the orifice 41 can easily form a dome-shaped droplet 71. As the glass fiber 2 passes through the droplet 71, a metal-coated glass fiber 11 which is glass fiber 2 coated with the metal coating 7 is obtained. If the dome-shaped droplet 71 is not formed when coating the glass fiber with the metal, the molten metal will flow out without staying around the orifice 41. Thus, preferably, the orifice 41 or the peripheral portion of the orifice 41 has poor wettability with molten metal.

For the orifice 41 or the peripheral portion of the orifice 41 to have poor wettability with molten metal, the orifice is preferably formed with ceramics. Examples of the ceramics for the orifice include alumina, zirconia, silicon carbide, boron nitride, silicon nitride, and aluminum nitride.

The shape of the orifice 41 may be circle, ellipse, rectangle, square, or trapezoid. During the production of the metal-coated glass fiber 11, the glass fiber 2 may swing perpendicularly to the moving direction in some cases. To ensure that the metal coating is formed even in such cases, the orifice 41 preferably has a shape such as rectangle or ellipse extending perpendicularly to the moving direction of the glass fiber 2.

The opening area of the orifice 41 is preferably 0.75 to 80 mm$^2$. If the opening area is smaller than 0.75 mm$^2$, the molten metal will not be smoothly discharged. If the opening area is larger than 80 mm$^2$, an excess amount of the molten metal will be discharged, so that the molten metal will flow out without staying around the orifice 41. In view of these points, the opening area of the orifice is more preferably 3 to 60 mm$^2$.

The metal feed rate from the orifice 41 can be appropriately adjusted by factors such as the shape of the orifice 41, the distance between the orifice 41 and the liquid level of the molten metal in the metal melting furnace 4, and the viscosity of the molten metal. The longer the distance between the orifice 41 and the liquid level of the molten metal in the metal melting furnace 4, the higher the metal feed rate; and the shorter the distance, the lower the metal feed rate. Preferably, the viscosity of the molten metal is appropriately adjusted because it varies greatly depending on the type or composition of the metal.

A material of an external wall surface of the metal melting furnace 4 with which the droplet 71 comes into contact can be appropriately selected from materials such as ceramics, metals, glass, and carbon, according to the temperature of the metal to be melted. Examples of the ceramics include alumina, zirconia, silicon carbide, boron nitride, silicon nitride, and aluminum nitride.

The metal melting furnace 4 can be appropriately heated using a heater or the like. The temperature inside the metal melting furnace needs to be higher than the melting point of the metal to be melted. Higher heating temperatures of the metal melting furnace tend to result in improved adhesion between the glass fiber 2 and the metal coating 7 (Reason 1) . Meanwhile, if the heating temperature of the metal melting furnace is too high, generation of sludge is likely to occur on the upper surface of the molten metal, depending on the composition of the metal, reducing the productivity of the metal-coated glass fiber (Reason 2). In addition, the metal melting furnace will need to use heat-resistant materials, which makes the metal melting furnace expensive (Reason 3). In view of Reasons 1 to 3, the temperature inside the metal melting furnace is preferably 400°C to 1000°C. In addition, for Reasons 2 and 3, it is not desirable if the temperature inside the metal melting furnace is too high. Thus, the upper limit of the temperature inside the metal melting furnace may be 850°C, preferably 750°C, more preferably 600°C, still more preferably 550°C. Meanwhile, if the temperature inside the metal melting furnace is low, it may take time to melt the metal materials, so that the lower limit of the temperature inside the metal melting furnace may be 450°C.

In addition, if the molten metal contains a material such as aluminum or titanium, a passivation film will be formed on the upper surface of the molten metal. Thus, even if the temperature inside the metal melting furnace is high, generation of sludge on the upper surface of the molten metal is less likely to occur, thus facilitating the production of the metal-coated glass fiber filler. In this view, the metal coating preferably contains at least one selected from the group consisting of aluminum and titanium. In the case where the metal coating contains at least one selected from the group consisting of aluminum and titanium, in order to enhance the adhesion between the metal coating and the glass fiber, the temperature inside the metal melting furnace may be 600°C to 800°C for Reason 1.

<Coating of glass fiber with a metal>

The glass fiber 2 passes by the metal melting furnace 4 while it is wound up by the winder 5. The glass fiber 2 is pushed against the droplet 71 from the metal melting furnace 4, whereby the metal coating 7 is formed on the glass fiber 2. Thus, the metal-coated glass fiber 11 is obtained. Here, the pushing machine 6 may be moved to move the glass fiber 2 toward the metal melting furnace 4 (in the direction of arrow B in Fig. 2) so as to push the glass fiber 2 in the central direction of the droplet 71; or the metal melting furnace 4 may be moved toward the glass fiber 2 to push the glass fiber 2 in the central direction of the droplet 71.

The amount of molten metal per unit time necessary to form the metal coating on the glass fiber varies depending on the diameter of the glass fiber (R: $\mu$m), the metal coating thickness (t: $\mu$m) , the winding speed (s: m/min), and the specific gravity of the coating metal (p: g/cm$^3$). Thus, the metal feed rate (M: g/min) into the orifice 41 can be estimated by the following formula (i):

$$M = (R \times t \times \pi \times s \times p) \times 10^{-6} \quad (i).$$

For example, as production conditions of glass fiber including a metal coating having a thickness of 1.0 $\mu$m, when the diameter of the glass fiber is 28 $\mu$m and the winding speed is 290 m/min, the ideal metal feed rate is 0.18 g/min as calculated from the formula (i). Yet, in order to form a metal coating with stability for a long period of time, the actual metal feed rate tends to be higher than as calculated.

The speed of the glass fiber 2 passing by the metal melting furnace 4 can be adjusted by the winding speed of the winder 5. The speed is preferably 100 to 5000 m/min. The winding speed also affects the diameter of the glass fiber, and is thus determined in view of the shape design of the metal-coated glass fiber. If the winding speed is lower than 100 m/min, the fiber diameter will be greater than 60 $\mu$m. If the winding speed is higher than 5000 m/min, breakage of the glass fiber occurs frequently, reducing the productivity of the glass fiber during production.

In the case where the pushing machine 6 is used, the pushing machine 6 and the glass fiber 2 are initially placed apart from each other. The pushing machine 6 includes a moving mechanism. The moving mechanism moves the pushing machine 6 to adjust the passing position of the glass fiber 2 such that it comes into contact with the dome-shaped droplet 71 formed on the orifice 41. The pushing machine is provided to determine the passing position of the glass fiber. The pushing machine is not particularly limited as long as it includes a moving mechanism that can be stably operated and is made using a heat-resistant material with a smooth surface.

Examples of the moving mechanism of the pushing machine include a stage with a bi- or multiaxial fine adjustment mechanism, and a robot with bi- or multiaxial moving mechanism. Examples of the heat-resistant material with a smooth surface include ceramics, graphite, and surface-polished metal. The material with a smooth surface functions as a guide capable of allowing the glass fiber 2 to pass therethrough when spinning of the glass fiber 2 starts, and also capable of maintaining the positional relationship between the glass fiber 2 and the droplet 71 formed on the orifice 41 during the formation of the metal coating. Thus, a preferred form of the material with a smooth surface is an article with a hole, a comb-shaped article, a plate with a groove, or a rod.

As for the article with a hole, examples of the shape of the hole include circle, ellipse, rectangle, square, and trapezoid. Alternatively, a portion of the periphery of the hole may be cut to form a groove. The opening area of the article with a hole is preferably 0.2 to 20 mm$^2$. If the opening area is smaller than 0.2 mm$^2$, it will be difficult to allow the glass fiber 2 to pass through the hole when spinning of the glass fiber 2 starts. In contrast, if the opening area is larger than 20 mm$^2$, the passing position of the glass fiber 2 tends to be unstable, so that it will be difficult to maintain the positional relationship between the glass fiber 2 and the droplet 71 of the molten metal. In view of these points, the opening area is more preferably 0.8 to 7 mm$^2$.

The length of teeth of the comb-shaped article is preferably 0.1 to 100 mm. If the teeth are shorter than 0.1 mm, it will be difficult for the comb-shaped article to guide the course of the glass fiber. If the teeth are longer than 100 mm, the teeth will be easily breakable. In view of these points, the length of the teeth is more preferably 1 to 100 mm. Use of a comb-shaped article as the pushing machine makes it easy to guide several strands of glass fiber through their courses.

The pushing machine may be disposed not only at the lower side but also the upper side of the metal melting furnace. The pushing machine may be disposed at either or both the upper side and the lower side of the metal melting furnace. In particular, it is more preferred to dispose the pushing machine at both the upper side and the lower side of the metal melting furnace because the glass fiber 2 can be precisely pushed against the droplet 71.

<Cutting of the metal-coated glass fiber>

The metal-coated glass fiber 11 is cut into a predetermined length, whereby the metal-coated glass fiber filler 1 can be obtained. Several strands of the metal-coated glass fiber 11 may be gathered into a bundle, and the bundle of strands of the metal-coated glass fiber 11 may be cut to give the metal-coated glass fiber filler 1 including a bundle of several strands of the glass fiber. When the filler 1 is formed of a bundle of strands, the fiber is less likely to be fluffy or loose, thus facilitating the production of a resin article including the metal-coated glass fiber filler 1 with good quality. A bundle of strands of the metal-coated glass fiber may be formed on-line during spinning or off-line after spinning. The metal-coated glass fiber can be cut by a known method, such as using a cutting machine. A machine such as a direct chopper may be used instead of the winder 5 to cut the metal-coated glass fiber 11 on-line during spinning to produce the metal-coated glass fiber filler 1.

[Electromagnetic shielding resin article]

The electromagnetic shielding metal-coated glass fiber filler of the present invention can be formed into a composite with resin to give an electromagnetic shielding resin article. Any known resin can be used to form a composite with the electromagnetic shielding metal-coated glass fiber filler of the present invention. Examples thereof include thermoplastic resins such as low density polyethylene, high density polyethylene, polypropylene, polyvinyl chloride, polystyrene, methacrylic resin, ABS resin, metallocene resin, polyamide, polyacetal, polycarbonate, polyphenylene ether, polyethylene terephthalate, polybutylene terephthalate, liquid crystal polymers, polyphenylene sulfide, polyimide, polyether sulfone, polyether ether ketone, and fluororesin; thermosetting resins such as epoxy resin, silicone resin, phenolic resin, unsaturated polyester resin, and polyurethane; rubber; and elastomer.

The electromagnetic shielding resin article may contain the electromagnetic shielding metal-coated glass fiber filler of the present invention in an amount of 0.01 to 30% by volume. The electromagnetic shielding metal-coated glass fiber filler of the present invention has good contact conductivity between the fiber fillers, i.e., between the metal coating surfaces, thus the metal-coated glass fiber filler content is preferably 10% by volume or less, more preferably 7% by volume or less.

The metal-coated glass fiber filler can be formed into a composite with resin by a known kneading method using a known device, according to the characteristics of the resin for the composite. If the resin is thermoplastic, a heat melting kneader is preferably used. For example, a device such as a monoaxial kneader, a biaxial kneader, a monoaxial kneading extruder, a biaxial kneading extruder, or a kneader or mixer provided with a heater may be used. An electromagnetic shielding resin article as a kneaded product of the metal-coated glass fiber filler and the resin can be molded by a known molding method, according to the characteristics and shape of the composite. If the resin is thermoplastic, a method such as injection molding or blow molding may be used. If the resin is thermosetting, a method such as hand lay-up molding, spray-up molding, pultrusion molding, SMC method, BMC method, or transfer molding may be used. Since the electromagnetic shielding metal-coated glass fiber filler of the present invention has good contact conductivity between metal coating surfaces, even when the fiber length is 50 mm or less, the resin can be imparted with good electromagnetic shielding effect. In view of this point, even a method such as injection molding that is not suitable for resin articles including long fiber can be favorably used for molding.

The molded composite (electromagnetic shielding resin article including the electromagnetic shielding metal-coated glass fiber filler) can be used for components of automobiles and electronic devices or for chassis or housings. Since the composite includes the metal-coated glass fiber filler, it can block electromagnetic waves to prevent or reduce interference by noise from electromagnetic waves, malfunction of equipment, or health risks from electromagnetic waves.

EXAMPLES

The present invention is more specifically described below with reference to examples and comparative examples, but the present invention is not limited to these examples. Metal-coated glass fiber fillers obtained in these examples were evaluated by the following methods.

(1) Measurement of the diameter of the glass fiber, the proportion of the metal in the fiber, the ratio of the metal coating to the entire circumference of the glass fiber, and calculation of the fiber specific gravity

The metal-coated glass fiber 11 produced was cut using a fiber cleaver (PK-12 available from Photon Kinetics), and cross sections were observed under a field emission scanning electron microscope (S-4500 available from Hitachi, Ltd.). A cross-sectional image of the fiber was used to observe the diameter of the glass fiber and the ratio of the metal coating to the entire circumference of the glass fiber. The cross-sectional image of the fiber was also used to measure the area ratio of the glass to the metal to determine the proportion of the metal in the fiber. The fiber specific gravity was calculated from the proportion of the metal in the fiber and the specific gravity of each metal and the glass (zinc: 7.1 $g/cm^3$, aluminum: 2.7 $g/cm^3$, titanium: 4.5 $g/cm^3$, E-glass: 2.5 $g/cm^3$).

(2) Contact conductivity of the metal-coated glass fiber filler The metal-coated glass fiber 11 was cut into lengths of 1 mm, 3 mm, and 30 mm. Each piece was regarded as the metal-coated glass fiber filler 1. For each of the examples and the comparative examples, the metal-coated glass fiber filler was weighed into a cylindrical container (diameter: 17 mm; height: 8 mm) made of an insulating material such that the filler volume was 200 $mm^3$ to fill the container with the filler. The packing of the metal-coated glass fiber filler in the cylindrical container simulates a metal-coated glass fiber filler in an amount of 11% by volume contained in a resin article.

A positive electrode and a negative electrode of a tester were inserted into the packing of the metal-coated glass fiber filler in the container with a gap of 17 mm between the electrodes to measure the electrical resistance of the packing for evaluation of the contact conductivity. The electromagnetic shielding effect of the resin article depends on the electrical conductivity of the resin article, and the electrical conductivity largely depends on the contact conductivity of the metal-coated glass fiber filler.

According to the evaluation, the glass fiber filler having an electrical resistance of less than 1 Ω is considered to be an excellent electromagnetic shielding metal-coated glass fiber filler having good contact conductivity.

In addition, some samples (Examples 4, 5, 12, 15, and 21) were additionally subjected to a moisture resistance test in an atmosphere at a temperature of 80°C and a relative humidity (RH) of 95% for 24 hours or 48 hours to measure the electrical resistance again after the test.

(3) Adhesion between the metal coating and the glass fiber The metal-coated glass fiber filler was crushed by manually rotating a pestle in a mortar to observe peeling between the metal coating and the glass under an optical microscope. When no peeling was observed in the filler after crushing by rotating the pestle 10 times, such filler was regarded as having good adhesion between the metal coating and the glass fiber.

Example 1

In the glass melting furnace 3, glass having an E-glass composition was melted at 1150°C. The glass fiber 2 was drawn out of the nozzle 31, passed through the graphite pushing machine 6 including an orifice having a diameter of 3.0 mm φ, and wound up by the winder 5. The winding speed of the winder 5 was adjusted such that the speed of the glass fiber 2 passing by the metal melting furnace 4 was 290 m/min. In order to produce the metal coating 7 made of an alloy of zinc (90% by mass) and aluminum (10% by mass), a mixture of pure zinc with a purity of 99.9% (90% by mass) and pure aluminum with a purity of 99.7% (10% by mass) was used as a raw material to obtain a molten metal; the melting temperature inside the metal melting furnace was 700°C; and the metal feed rate was 1.22 g/min.

After the winder 5 started winding up the glass fiber 2, an XY stage was used to push out the graphite pushing machine 6 in the direction of arrow B in Fig. 2 to adjust the passing position of the glass fiber 2 to a position of the droplet 71 formed on the orifice 41, and then the glass fiber 2 was pushed into the droplet 71. Thus, the metal-coated glass fiber 11 was obtained.

The operation to obtain the metal-coated glass fiber 11 was performed for 10 minutes, and the metal-coated glass fiber 11 obtained by this operation was subjected to the evaluations (1) to (3) described above, and was evaluated as the metal-coated glass fiber filler 1. In the resultant metal-coated glass fiber 11, the glass fiber 2 had a fiber diameter of 28 μm. Table 1 shows other results. In the resultant filler 1, the ratio of the metal coating to the entire circumference of the glass fiber was 40%, and the filler included the metal-uncoated surface 21. Yet, surprisingly, the filler exhibited a good result in the evaluation (2), and was found to be an excellent electromagnetic shielding metal-coated glass fiber filler. In the evaluation (3), the adhesion between the metal coating and the glass fiber was found to be good. In this example, no sludge was observed on the molten metal even when the operation to obtain the metal-coated glass fiber 11 was performed for one hour.

Example 2

The metal-coated glass fiber 11 was produced in the same manner as in Example 1, except that in order to produce the metal coating 7 made of an alloy of zinc (80% by mass) and aluminum (20% by mass), a mixture of pure zinc with a purity of 99.9% (80% by mass) and pure aluminum with a purity of 99.7% (20% by mass) was used as a raw material to obtain a molten metal; the melting temperature inside the metal melting furnace was 700°C; and the metal feed rate was 1.12 g/min. Subsequently, the metal-coated glass fiber 11 was subjected to the evaluations (1) to (3), and was evaluated as the metal-coated glass fiber filler 1. In the resultant metal-coated glass fiber 11, the glass fiber 2 had a fiber diameter of 28 μm. Table 1 shows other results. In the resultant filler 1, the ratio of the metal coating to the entire circumference of the glass fiber was 40%, and the filler included the metal-uncoated surface 21. Yet, surprisingly, the filler exhibited a good result in the evaluation (2), and was found to be an excellent electromagnetic shielding metal-coated glass fiber filler. In the evaluation (3), the adhesion between the metal coating and the glass fiber was found to be good. In this example, no sludge was observed on the molten metal even when the operation to obtain the metal-coated glass fiber 11 was performed for one hour.

Example 3

The metal-coated glass fiber 11 was produced in the same manner as in Example 1, except that in order to produce the metal coating 7 made of an alloy of zinc (70% by mass) and aluminum (30% by mass), a mixture of pure zinc with a purity of 99.9% (70% by mass) and pure aluminum with a purity of 99.7% (30% by mass) was used as a raw material to obtain a molten metal; the melting temperature inside the metal melting furnace was 700°C; and the metal feed rate was 1.07 g/min. Subsequently, the metal-coated glass fiber 11 was subjected to the evaluations (1) to (3), and was evaluated as the metal-coated glass fiber filler 1. In the resultant metal-coated glass fiber 11, the glass fiber 2 had a fiber diameter of 28 μm. Table 1 shows other results. In the resultant filler 1, the ratio of the metal coating to the entire circumference of the glass fiber was 40%, and the filler included the metal-uncoated surface 21. Yet, surprisingly, the filler exhibited a good result in the evaluation (2), and was found to be an excellent electromagnetic shielding metal-coated glass fiber filler. In the evaluation (3), the adhesion between the metal coating and the glass fiber was found to be good. In this example, no sludge was observed on the molten metal even when the operation to obtain the metal-coated glass fiber 11 was performed for one hour.

Example 4

In the glass melting furnace 3, glass having an E-glass composition was melted at 1250°C, and the winding speed of the winder 5 was adjusted such that the speed of the glass fiber 2 passing by the metal melting furnace 4 was 1000 m/min. The metal-coated glass fiber 11 was produced in the same manner as in Example 1, except that in order to produce the metal coating 7 made of an alloy of zinc (99.9% by mass) and aluminum (0.1% by mass), a mixture of pure zinc with a purity of 99.99% (99.9% by mass) and pure aluminum with a purity of 99.7% (0.1% by mass) was used as a raw material to obtain a molten metal; the melting temperature inside the metal melting furnace was 700°C; and the metal feed rate from the orifice 41 was 0.96 g/min. Subsequently, the metal-coated glass fiber 11 was subjected to the evaluations (1) to (3), and was evaluated as the metal-coated glass fiber filler 1. In the resultant metal-coated glass fiber 11, the glass fiber 2 had a fiber diameter of 13 μm. Table 1 shows other results. In the resultant filler 1, the ratio of the metal coating to the entire circumference of the glass fiber was 40%, and the filler included the metal-uncoated surface 21. Yet, surprisingly, the filler exhibited a good result in the evaluation (2), and was found to be an excellent electromagnetic shielding metal-coated glass fiber filler. In the evaluation (3), the adhesion between the metal coating and the glass fiber was found to be good. In this example, no sludge was observed on the molten metal even when the operation to obtain the metal-coated glass fiber 11 was performed for one hour.

Example 5

The metal-coated glass fiber 11 was produced in the same manner as in Example 4, except that in order to produce the metal coating 7 made of an alloy of zinc (99.5% by mass) and aluminum (0.5% by mass), a mixture of pure zinc with a purity of 99.99% (99.5% by mass) and pure aluminum with a purity of 99.7% (0.5% by mass) was used as a raw material to obtain a molten metal. Subsequently, the metal-coated glass fiber 11 was subjected to the evaluations (1) to (3), and was evaluated as the metal-coated glass fiber filler 1. In the resultant metal-coated glass fiber 11, the glass fiber 2 had a fiber diameter of 13 $\mu$m. Table 1 shows other results. In the resultant filler 1, the ratio of the metal coating to the entire circumference of the glass fiber was 100%.

The filler exhibited a good result in the evaluation (2), and was found to be an excellent electromagnetic shielding metal-coated glass fiber filler. In the evaluation (3), the adhesion between the metal coating and the glass fiber was found to be good. In this example, no sludge was observed on the molten metal even when the operation to obtain the metal-coated glass fiber 11 was performed for one hour.

Example 6

The metal-coated glass fiber 11 was produced in the same manner as in Example 5, except that the metal was melted at 500°C. Subsequently, the metal-coated glass fiber 11 was subjected to the evaluations (1) to (3), and was evaluated as the metal-coated glass fiber filler 1. In the resultant metal-coated glass fiber 11, the glass fiber 2 had a fiber diameter of 13 $\mu$m. Table 1 shows other results. In the resultant filler 1, the ratio of the metal coating to the entire circumference of the glass fiber was 100%.

The filler exhibited a good result in the evaluation (2), and was found to be an excellent electromagnetic shielding metal-coated glass fiber filler. In the evaluation (3), the adhesion between the metal coating and the glass fiber was found to be good. In this example, no sludge was observed on the molten metal even when the operation to obtain the metal-coated glass fiber 11 was performed for one hour.

Examples 7 to 10

In each of these examples, the metal-coated glass fiber 11 was produced in the same manner as in Example 6, except that the proportion of the metal in the fiber and the ratio of the metal coating to the entire circumference of the glass fiber were changed to the values shown in Table 1. Subsequently, the metal-coated glass fiber 11 was subjected to the evaluations (1) to (3), and was evaluated as the metal-coated glass fiber filler 1. In the resultant metal-coated glass fiber 11, the glass fiber 2 had a fiber diameter of 13 $\mu$m. Table 1 shows other results.

Each of these fillers exhibited a good result in the evaluation (2), and was found to be an excellent electromagnetic shielding metal-coated glass fiber filler. In the evaluation (3), the adhesion between the metal coating and the glass fiber was found to be good. In each of these examples, no sludge was observed on the molten metal even when the operation to obtain the metal-coated glass fiber 11 was performed for one hour.

Example 11

The metal-coated glass fiber 11 was produced in the same manner as in Example 6, except that in order to produce the metal coating 7 made of an alloy of zinc (97% by mass) and aluminum (3% by mass), a mixture of pure zinc with a purity of 99.99% (97% by mass) and pure aluminum with a purity of 99.7% (3% by mass) was used as a raw material to obtain a molten metal; and the metal feed rate was 0.94 g/min. Subsequently, the metal-coated glass fiber 11 was subjected to the evaluations (1) to (3), and was evaluated as the metal-coated glass fiber filler 1. In the resultant metal-coated glass fiber 11, the glass fiber 2 had a fiber diameter of 13 $\mu$m. Table 1 shows other results. In the resultant filler 1, the ratio of the metal coating to the entire circumference of the glass fiber was 100%.

The filler exhibited a good result in the evaluation (2), and was found to be an excellent electromagnetic shielding metal-coated glass fiber filler. In the evaluation (3), the adhesion between the metal coating and the glass fiber was found to be good. In this example, no sludge was observed on the molten metal even when the operation to obtain the metal-coated glass fiber 11 was performed for one hour.

Example 12

In the glass melting furnace 3, glass having an E-glass composition was melted at 1250°C, and the winding speed of the winder 5 was adjusted such that the speed of the glass fiber 2 passing by the metal melting furnace 4 was 1000 m/min. The metal-coated glass fiber 11 was produced in the same manner as in Example 1, except that in order to produce the metal coating 7 made of an alloy of zinc (99.9% by mass) and titanium (0.1% by mass), a mixture of pure zinc with a purity of 99.99% (99.9% by mass) and pure titanium with a purity of 99.9% (0.1% by mass) was used as a raw material to obtain a molten metal; the melting temperature inside the metal melting furnace was 500°C; and the metal feed rate from the orifice 41 was 0.70 g/min. Subsequently, the metal-coated glass fiber 11 was subjected to the evaluations (1) to (3), and was evaluated as the metal-coated glass fiber filler 1. In the resultant metal-coated glass fiber 11, the glass fiber 2 had a fiber diameter of 13 $\mu$m. Table 1 shows other results. In the resultant filler 1, the ratio of the metal coating to the entire circumference of the glass fiber was 40%, and the filler included the metal-uncoated surface 21. Yet, surprisingly, the filler exhibited a good result in the evaluation (2), and was found to be an excellent electromagnetic shielding metal-coated glass fiber filler. In the evaluation (3), the adhesion between the metal coating and the glass fiber was found to be good. In this example, no sludge was observed on the molten metal even when the operation to obtain the metal-coated glass fiber 11 was performed for one hour.

Example 13

The metal-coated glass fiber 11 was produced in the same manner as in Example 12, except that in order to produce the metal coating 7 made of an alloy of zinc (99.8% by mass) and titanium (0.2% by mass), a mixture of pure zinc with a purity of 99.99% (99.8% by mass) and pure titanium with a purity of 99.9% (0.2% by mass) was used as a raw material to obtain a molten metal. Subsequently, the metal-coated glass fiber 11 was subjected to the evaluations (1) to (3), and was evaluated as the metal-coated glass fiber filler 1. In the resultant metal-coated glass fiber 11, the glass fiber 2 had a fiber diameter of 13 $\mu$m. Table 1 shows other results. In the resultant filler 1, the ratio of the metal coating to the entire circumference of the glass fiber was 40%, and the filler included the metal-uncoated surface 21. Yet, surprisingly, the filler exhibited a good result in the evaluation (2), and was found to be an excellent electromagnetic shielding metal-coated glass fiber filler. In the evaluation (3), the adhesion between the metal coating and the glass fiber was found to be good. In this example, no sludge was observed on the molten metal even when the operation to obtain the metal-coated glass fiber 11 was performed for one hour.

Example 14

The metal-coated glass fiber 11 was produced in the same manner as in Example 12, except that in order to produce the metal coating 7 made of an alloy of zinc (99.7% by mass) and titanium (0.3% by mass), a mixture of pure zinc with a purity of 99.99% (99.7% by mass) and pure titanium with a purity of 99.9% (0.3% by mass) was used as a raw material to obtain a molten metal. Subsequently, the metal-coated glass fiber 11 was subjected to the evaluations (1) to (3), and was evaluated as the metal-coated glass fiber filler 1. In the resultant metal-coated glass fiber 11, the glass fiber 2 had a fiber diameter of 13 $\mu$m. Table 1 shows other results. In the resultant filler 1, the ratio of the metal coating to the entire circumference of the glass fiber was 40%, and the filler included the metal-uncoated surface 21. Yet, surprisingly, the filler exhibited a good result in the evaluation (2), and was found to be an excellent electromagnetic shielding metal-coated glass fiber filler. In the evaluation (3), the adhesion between the metal coating and the glass fiber was found to be good. In this example, no sludge was observed on the molten metal even when the operation to obtain the metal-coated glass fiber 11 was performed for one hour.

Example 15

The metal-coated glass fiber 11 was produced in the same manner as in Example 12, except that in order to produce the metal coating 7 made of an alloy of zinc (99.5% by mass) and titanium (0.5% by mass), a mixture of pure zinc with a purity of 99.99% (99.5% by mass) and pure titanium with a purity of 99.9% (0.5% by mass) was used as a raw material to obtain a molten metal. Subsequently, the metal-coated glass fiber 11 was subjected to the evaluations (1) to (3), and was evaluated as the metal-coated glass fiber filler 1. In the resultant metal-coated glass fiber 11, the glass fiber 2 had a fiber diameter of 13 $\mu$m. Table 1 shows other results. In the resultant filler 1, the ratio of the metal coating to the entire circumference of the glass fiber was 40%.
The filler exhibited a good result in the evaluation (2), and was found to be an excellent electromagnetic shielding metal-coated glass fiber filler. In the evaluation (3), the adhesion between the metal coating and the glass fiber was found to be good. In this example, no sludge was observed on the molten metal even when the operation to obtain the metal-coated glass fiber 11 was performed for one hour.

Examples 16 to 19

In each of these examples, the metal-coated glass fiber 11 was produced in the same manner as in Example 15, except that the proportion of the metal in the fiber and the ratio of the metal coating to the entire circumference of the glass fiber were changed to the values as shown in Table 1. Subsequently, the metal-coated glass fiber 11 was subjected to the evaluations (1) to (3), and was evaluated as the metal-coated glass fiber filler 1. In the resultant metal-coated glass fiber 11, the glass fiber 2 had a fiber diameter of 13 $\mu$m. Table 1 shows other results.
Each filler exhibited a good result in the evaluation (2), and was found to be an excellent electromagnetic shielding metal-coated glass fiber filler. In the evaluation (3), the adhesion between the metal coating and the glass fiber was found to be good. In each of these examples, no sludge was observed on the molten metal even when the operation to obtain the metal-coated glass fiber 11 was performed for one hour.

Example 20

The metal-coated glass fiber 11 was produced in the same manner as in Example 12, except that in order to produce the metal coating 7 made of an alloy of zinc (99.0% by mass) and titanium (1. 0% by mass), a mixture of pure zinc with a purity of 99.99% (99.0% by mass) and pure titanium with a purity of 99.9% (1.0% by mass) was used as a raw material to obtain a molten metal; and the metal was melted at 700°C. Subsequently, the metal-coated glass fiber 11 was subjected to the evaluations (1) to (3), and was evaluated as the metal-coated glass fiber filler 1. In the resultant metal-coated glass fiber 11, the glass fiber 2 had a fiber diameter of 13 $\mu$m. Table 1 shows other results. In the resultant filler 1, the ratio of the metal coating to the entire circumference of the glass fiber was 40%.

The filler exhibited a good result in the evaluation (2), and was found to be an excellent electromagnetic shielding metal-coated glass fiber filler. In the evaluation (3), the adhesion between the metal coating and the glass fiber was found to be good. In this example, no sludge was observed on the molten metal even when the operation to obtain the metal-coated glass fiber 11 was performed for one hour.

Example 21

Glass having an E-glass composition was melted in the glass melting furnace 3 at 1250°C, and the winding speed of the winder 5 was adjusted such that the speed of the glass fiber 2 passing by the metal melting furnace 4 was 1000 m/min. The metal-coated glass fiber 11 was produced in the same manner as in Example 1, except that in order to produce the metal coating 7 made of an alloy of zinc (99.45% by mass), aluminum (0.05% by mass), and titanium (0.5% by mass), a mixture of pure zinc with a purity of 99.99% (99.45% by mass), pure aluminum with a purity of 99.7% (0.05% by mass), and pure titanium with a purity of 99.9% (0.5% by mass) was used as a raw material to obtain a molten metal; the melting temperature inside the metal melting furnace was 600°C; and the metal feed rate from the orifice 41 was 0.67 g/min. Subsequently, the metal-coated glass fiber 11 was subjected to the evaluations (1) to (3), and was evaluated as the metal-coated glass fiber filler 1. In the resultant metal-coated glass fiber 11, the glass fiber 2 had a fiber diameter of 13 $\mu$m. Table 1 shows other results. In the resultant filler 1, the ratio of the metal coating to the entire circumference of the glass fiber was 80%, and the filler included the metal-uncoated surface 21. Yet, the filler exhibited a good result in the evaluation (2), and was found to be an excellent electromagnetic shielding metal-coated glass fiber filler. In the evaluation (3), the adhesion between the metal coating and the glass fiber was found to be good. In this example, no sludge was observed on the molten metal even when the operation to obtain the metal-coated glass fiber 11 was performed for one hour.

Comparative Example 1

The metal-coated glass fiber 11 was produced in the same manner as in Example 1, except that in order to produce the metal coating 7 made of aluminum, pure aluminum with a purity of 99.7% was used as a raw material to obtain a molten metal; the melting temperature inside the metal melting furnace was 700°C; and the metal feed rate was 0.49 g/min. Subsequently, the metal-coated glass fiber 11 was subjected to the evaluations (1) to (3), and was evaluated as the metal-coated glass fiber filler 1. In the resultant metal-coated glass fiber 11, the glass fiber 2 had a fiber diameter of 28 $\mu$m. Table 1 shows other results. In the resultant filler 1, the ratio of the metal coating to the entire circumference of the glass fiber was 40%.

According to the result of the evaluation (2), the electrical resistance was 1 $\Omega$ or higher. This indicates that the resultant filler 1 had lower contact conductivity than the fillers of Examples 1 to 21. In the evaluation (3), the adhesion between the metal coating and the glass fiber was good, and no peeling was observed between the metal coating and the glass fiber. No sludge was observed on the molten metal even when the operation to obtain the metal-coated glass fiber 11 was performed for one hour.

Comparative Example 2

The metal-coated glass fiber 11 was produced in the same manner as in Example 1, except that in order to produce the metal coating 7 made of an alloy of zinc (10% by mass) and aluminum (90% by mass), a mixture of pure zinc with a purity of 99.9% (10% by mass) and pure aluminum with a purity of 99.7% (90% by mass) was used as a raw material to obtain a molten metal; the melting temperature inside the metal melting furnace was 700°C; and the metal feed rate was 0.57 g/min. Subsequently, the metal-coated glass fiber 11 was subjected to the evaluations (1) to (3), and was evaluated as the metal-coated glass fiber filler 1. In the resultant metal-coated glass fiber 11, the glass fiber 2 had a fiber diameter of 28 µm. Table 1 shows other results. In the resultant filler 1, the ratio of the metal coating to the entire circumference of the glass fiber was 40%.

According to the result of the evaluation (2), the electrical resistance was 1 Ω or higher. This indicates that the resultant filler 1 had lower contact conductivity than the fillers of Examples 1 to 21. In the evaluation (3), the adhesion between the metal coating and the glass fiber was good, and no peeling was observed between the metal coating and the glass fiber. No sludge was observed on the molten metal even when the operation to obtain the metal-coated glass fiber 11 was performed for one hour.

Reference Example 1

The metal-coated glass fiber 11 was produced in the same manner as in Example 1, except that in order to produce the metal coating 7 made of zinc, pure zinc with a purity of 99.9% was used as a raw material to obtain a molten metal; the melting temperature inside the metal melting furnace was 700°C; and the metal feed rate was 1.28 g/min. Subsequently, the metal-coated glass fiber 11 was subjected to the evaluations (1) to (3), and was evaluated as the metal-coated glass fiber filler 1. In the resultant metal-coated glass fiber 11, the glass fiber 2 had a fiber diameter of 28 µm. Table 1 shows other results. In the resultant filler 1, the ratio of the metal coating to the entire circumference of the glass fiber was 40%.

According to the result of the evaluation (2), the contact conductivity was good. According to the result of the evaluation (3), the adhesion between the metal coating and the glass fiber was good, and no peeling was observed between the metal coating and the glass fiber. When the operation to obtain the metal-coated glass fiber 11 was performed for one hour, sludge was observed on the molten metal.

Reference Example 2

The metal-coated glass fiber 11 was produced in the same manner as in Reference Example 1, except that glass having an E-glass composition was melted in the glass melting furnace 3 at 1250°C; the winding speed of the winder 5 was adjusted such that the speed of the glass fiber 2 passing by the metal melting furnace 4 was 1000 m/min; pure zinc with a purity of 99.99% was melted at 500°C; and the metal feed rate from the orifice 41 was 0.96 g/min. Subsequently, the metal-coated glass fiber 11 was subjected to the evaluations (1) to (3), and was evaluated as the metal-coated glass fiber filler 1. In the resultant metal-coated glass fiber 11, the glass fiber 2 had a fiber diameter of 13 µm. Table 1 shows other results. In the resultant filler 1, the ratio of the metal coating to the entire circumference of the glass fiber was 40%.

According to the result of the evaluation (2), the contact conductivity was good. However, in the evaluation (3) of the adhesion between the metal coating and the glass fiber, peeling was observed between the metal coating and the glass fiber. No sludge was observed on the molten metal even when the operation to obtain the metal-coated glass fiber 11 was performed for one hour.

[Adhesion between the metal coating and the glass fiber]

As shown in Reference Example 2, the metal-coated glass fiber coated with pure zinc melted at 500°C that is close to the melting point of zinc exhibited poor adhesion between the metal coating and the glass fiber. In contrast, the glass fiber coated with a zinc-aluminum alloy or a zinc-titanium alloy melted at 500°C that is close to the melting point of zinc exhibited good adhesion between the glass fiber and the metal coating (Examples 6 to 19).

[Contact conductivity of the metal-coated glass fiber coated with a zinc-aluminum alloy or a zinc-titanium alloy]

According to the results in Table 1, the metal-coated glass fiber coated with a zinc-aluminum alloy or a zinc-titanium alloy having a zinc content of 50% by mass or more in each of Examples 1 to 21 exhibited higher contact conductivity than the metal-coated glass fiber coated with pure aluminum in Comparative Example 1 and the metal-coated glass fiber coated with a zinc-aluminum alloy having a zinc content of 10% by mass in Comparative Example 2.

[Comparison between the metal coating made of a zinc-aluminum alloy and the metal coating made of a zinc-titanium alloy]

The glass fillers of Examples 4, 5, 12, 15, and 21 were kept in an atmosphere at a temperature of 80°C and a relative humidity (RH) of 95% for 24 hours or 48 hours for a moisture resistance test. After the test, the evaluation (2) was performed. According to the results in Table 2, the metal-coated glass fiber in each of Examples 12, 15, and 21 exhibited good contact conductivity even after the moisture resistance test. As is clear from these results, the metal-coated glass fiber coated with a metal coating made of a zinc-titanium alloy was able to maintain the initial contact conductivity even when kept in a high-temperature and high-humidity atmosphere and exhibited good resistance to a high-temperature and high-humidity atmosphere. In view of these evaluation results, the zinc-titanium alloy may contain titanium in an amount of 0.1 to 1.0% by mass.

[Table 1]

| | Composition of alloy forming metal coating (% by mass) | | | Glass fiber diameter ($\mu$m) | Proportion of metal in fiber (% by volume) | Specific gravity (g/cm$^3$) | Ratio of metal coating to entire circumference of glass fiber (%) | Electrical resistance ($\Omega$) | | | Adhesion between glass fiber and metal coating |
|---|---|---|---|---|---|---|---|---|---|---|---|
| | Zinc | Aluminum | Titanium | | | | | 1 mm | 3 mm | 30 mm | |
| Example 1 | 90 | 10 | 0 | 28 | 50 | 4.6 | 40 | <1 | <1 | <1 | No peeling |
| Example 2 | 80 | 20 | 0 | 28 | 50 | 4.4 | 40 | <1 | <1 | <1 | No peeling |
| Example 3 | 70 | 30 | 0 | 28 | 50 | 4.2 | 40 | <1 | <1 | <1 | No peeling |
| Example 4 | 99.9 | 0.1 | 0 | 13 | 50 | 4.8 | 40 | <1 | <1 | <1 | No peeling |
| Example 5 | 99.5 | 0.5 | 0 | 13 | 50 | 4.8 | 100 | <1 | <1 | <1 | No peeling |
| Example 6 | 99.5 | 0.5 | 0 | 13 | 50 | 4.8 | 100 | <1 | <1 | <1 | No peeling |
| Example 7 | 99.5 | 0.5 | 0 | 13 | 70 | 5.7 | 100 | <1 | <1 | <1 | No peeling |
| Example 8 | 99.5 | 0.5 | 0 | 13 | 70 | 5.7 | 40 | <1 | <1 | <1 | No peeling |
| Example 9 | 99.5 | 0.5 | 0 | 13 | 30 | 3.9 | 80 | <1 | <1 | <1 | No peeling |
| Example 10 | 99.5 | 0.5 | 0 | 13 | 20 | 3.4 | 30 | <1 | <1 | <1 | No peeling |
| Example 11 | 97 | 3 | 0 | 13 | 50 | 4.7 | 100 | <1 | <1 | <1 | No peeling |
| Example 12 | 99.9 | 0 | 0.1 | 13 | 50 | 4.8 | 40 | <1 | <1 | <1 | No peeling |
| Example 13 | 99.8 | 0 | 0.2 | 13 | 50 | 4.8 | 40 | <1 | <1 | <1 | No peeling |
| Example 14 | 99.7 | 0 | 0.3 | 13 | 50 | 4.8 | 40 | <1 | <1 | <1 | No peeling |
| Example 15 | 99.5 | 0 | 0.5 | 13 | 50 | 4.8 | 40 | <1 | <1 | <1 | No peeling |
| Example 16 | 99.5 | 0 | 0.5 | 13 | 60 | 5.3 | 30 | <1 | <1 | <1 | No peeling |
| Example 17 | 99.5 | 0 | 0.5 | 13 | 80 | 6.2 | 100 | <1 | <1 | <1 | No peeling |
| Example 18 | 99.5 | 0 | 0.5 | 13 | 50 | 4.8 | 80 | <1 | <1 | <1 | No peeling |
| Example 19 | 99.5 | 0 | 0.5 | 13 | 30 | 3.9 | 20 | <1 | <1 | <1 | No peeling |
| Example 20 | 99.0 | 0 | 1.0 | 13 | 50 | 4.8 | 40 | <1 | <1 | <1 | No peeling |
| Example 21 | 99.45 | 0.05 | 0.5 | 13 | 40 | 4.4 | 80 | <1 | <1 | <1 | No peeling |
| Comparative Example 1 | 0 | 100 | 0 | 28 | 50 | 2.6 | 40 | >10$^6$ | 20 | 10 | No peeling |

16

(continued)

| | Composition of alloy forming metal coating (% by mass) | | | Glass fiber diameter (μm) | Proportion of metal in fiber (% by volume) | Specific gravity (g/cm³) | Ratio of metal coating to entire circumference of glass fiber (%) | Electrical resistance (Ω) | | | Adhesion between glass fiber and metal coating |
| | Zinc | Aluminum | Titanium | | | | | 1 mm | 3 mm | 30 mm | |
|---|---|---|---|---|---|---|---|---|---|---|---|
| Comparative Example 2 | 10 | 90 | 0 | 28 | 50 | 2.9 | 40 | $>10^6$ | 10 | 5 | No peeling |
| Referrence Example 1 | 100 | 0 | 0 | 28 | 50 | 4.8 | 40 | <1 | <1 | <1 | No peeling |
| Referrence Example 2 | 100 | 0 | 0 | 13 | 50 | 4.8 | 40 | <1 | <1 | <1 | Peeling occurred |

[Table 2]

| | Composition of alloy forming metal coating (% by mass) | | | Electrical resistance (Ω) after moisture resistance test (80°C and 95% RH) | | |
|---|---|---|---|---|---|---|
| | Zinc | Aluminum | Titanium | 0h | 24h | 48h |
| Example 4 | 99.9 | 0.1 | 0 | <1 | 2000 | 10000 |
| Example 5 | 99.5 | 0.5 | 0 | <1 | 2000 | 10000 |
| Example 12 | 99.9 | 0 | 0.1 | <1 | <1 | <1 |
| Example 15 | 99.5 | 0 | 0.5 | <1 | <1 | <1 |
| Example 21 | 99.45 | 0.05 | 0.5 | <1 | <1 | <1 |

REFERENCE SIGNS LIST

1      metal-coated glass fiber filler

11     metal-coated glass fiber

2      glass fiber

21     metal-uncoated surface

3      glass melting furnace

31     bushing nozzle

4      metal melting furnace

41     orifice for discharging molten metal to the outside

5      winder

6      pushing machine

7      metal coating

71     molten metal droplet

**Claims**

1.  An electromagnetic shielding metal-coated glass fiber filler to be used as a composite with resin, the glass fiber filler comprising:

    glass fiber; and
    a metal coating in a longitudinal direction of the glass fiber,
    wherein the metal coating is made of an alloy containing a first metal consisting of zinc and a second metal consisting of a metal having a lower oxidation-reduction potential than zinc,
    the second metal is at least one selected from the group consisting of barium, strontium, calcium, magnesium, beryllium, aluminum, titanium, zirconium, manganese, and tantalum, and
    the alloy contains the first metal in an amount of 50% by mass or more.

2.  The electromagnetic shielding metal-coated glass fiber filler according to claim 1,

wherein the volume ratio of the glass fiber is 5 to 95% by volume, and the volume ratio of the metal coating is 5 to 95% by volume.

3. The electromagnetic shielding metal-coated glass fiber filler according to claim 1 or 2, wherein the glass fiber is formed of an E-glass composition.

4. The electromagnetic shielding metal-coated glass fiber filler according to any one of claims 1 to 3, wherein the alloy contains the second metal in an amount of 0.01% by mass or more.

5. The electromagnetic shielding metal-coated glass fiber filler according to any one of claims 1 to 4, wherein the alloy contains the second metal in an amount of 30% by mass or less.

6. The electromagnetic shielding metal-coated glass fiber filler according to any one of claims 1 to 5, wherein the alloy substantially consists of the first metal and the second metal.

7. The electromagnetic shielding metal-coated glass fiber filler according to any one of claims 1 to 6, wherein the second metal is at least one selected from the group consisting of aluminum and titanium.

8. The electromagnetic shielding metal-coated glass fiber filler according to any one of claims 1 to 7, wherein the glass fiber has a metal-uncoated surface in the longitudinal direction of the glass fiber.

9. The electromagnetic shielding metal-coated glass fiber filler according to claim 8, further comprising a silane coupling-treated layer on the metal-uncoated surface.

10. The electromagnetic shielding metal-coated glass fiber filler according to any one of claims 1 to 9, wherein the glass fiber has a length of 0.01 to 50 mm.

11. The electromagnetic shielding metal-coated glass fiber filler according to any one of claims 1 to 10, wherein the glass fiber has a diameter of 1 to 100 $\mu$m.

12. The electromagnetic shielding metal-coated glass fiber filler according to any one of claims 1 to 11, wherein the ratio of the metal coating to the entire circumference of the glass fiber is 5% or more.

13. The electromagnetic shielding metal-coated glass fiber filler according to any one of claims 1 to 12, wherein the metal coating is formed by hot-dipping.

14. A method for manufacturing an electromagnetic shielding metal-coated glass fiber filler to be used as a composite with resin, the method comprising:

   melting a metal material in a metal melting furnace to form molten metal;
   forming a molten metal droplet by discharging a molten metal from an orifice provided to the metal melting furnace for discharging the molten metal to the outside;
   bringing glass fiber being drawn out of a bushing nozzle of a glass melting furnace into contact with the droplet; and
   cutting metal-coated glass fiber,
   wherein the metal material contains a first metal consisting of zinc and a second metal consisting of a metal having a lower oxidation-reduction potential than zinc,
   the second metal is at least one selected from the group consisting of barium, strontium, calcium, magnesium, beryllium, aluminum, titanium, zirconium, manganese, and tantalum, and
   the metal material contains the first metal in an amount of 50% by mass or more.

15. An electromagnetic shielding resin article comprising:
   the metal-coated glass fiber filler according to any one of claims 1 to 13.

16. The electromagnetic shielding resin article according to claim 15, wherein the electromagnetic shielding metal-coated glass fiber filler content is 0.01 to 30% by volume.

FIG.1

(a)　　　　　　　　　　　　　　(b)

FIG.2

FIG.3

4

2

71

41

7

11

**EP 3 372 727 A1**

## INTERNATIONAL SEARCH REPORT

International application No.

PCT/JP2016/082274

A. CLASSIFICATION OF SUBJECT MATTER
*D06M11/83*(2006.01)i, *C03C25/10*(2006.01)i, *D06M101/00*(2006.01)n

According to International Patent Classification (IPC) or to both national classification and IPC

B. FIELDS SEARCHED

Minimum documentation searched (classification system followed by classification symbols)
D06M11/00-11/84, C03C25/00-25/70

Documentation searched other than minimum documentation to the extent that such documents are included in the fields searched
Jitsuyo Shinan Koho        1922-1996   Jitsuyo Shinan Toroku Koho   1996-2017
Kokai Jitsuyo Shinan Koho   1971-2017   Toroku Jitsuyo Shinan Koho   1994-2017

Electronic data base consulted during the international search (name of data base and, where practicable, search terms used)
Japio-GPG/FX, JSTPlus/JST7580/JSTChina(JDreamIII)

C. DOCUMENTS CONSIDERED TO BE RELEVANT

| Category* | Citation of document, with indication, where appropriate, of the relevant passages | Relevant to claim No. |
|---|---|---|
| Y | KR 10-2014-0001349 A  (WIN & WIN Co., Ltd.), 07 January 2014 (07.01.2014), claims; 0007, 0013 to 0015, 0040, 0049 (Family: none) | 1-16 |
| Y | CN 102816952 A  (Shaoxing University), 12 December 2012 (12.12.2012), 0002 (Family: none) | 1-7,10-16 |
| Y | JP 60-113996 A  (Nippon Sheet Glass Co., Ltd.), 20 June 1985 (20.06.1985), page 3, upper right column; fig. 2 (Family: none) | 8 |

[X] Further documents are listed in the continuation of Box C.     [ ] See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

Date of the actual completion of the international search
17 January 2017 (17.01.17)

Date of mailing of the international search report
31 January 2017 (31.01.17)

Name and mailing address of the ISA/
Japan Patent Office
3-4-3,Kasumigaseki,Chiyoda-ku,
Tokyo 100-8915,Japan

Authorized officer

Telephone No.

Form PCT/ISA/210 (second sheet) (January 2015)

22

**INTERNATIONAL SEARCH REPORT**

| International application No. |
| --- |
| PCT/JP2016/082274 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | JP 2012-236944 A (Mitsubishi Engineering-Plastics Corp.), 06 December 2012 (06.12.2012), 0053 (Family: none) | 9 |
| A | JP 60-77151 A (Asahi Glass Co., Ltd.), 01 May 1985 (01.05.1985), (Family: none) | 1-16 |
| A | JP 30-9336 B (Owens Corning Fiberglass Corp.), 21 December 1955 (21.12.1955), (Family: none) | 1-16 |
| A | WO 1996/10901 A1 (CHUNG, Deborah, Duen, Ling), 11 April 1996 (11.04.1996), & US 5827997 A1 | 1-16 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP S6129083 B
- JP S60113996 A
- JP 2012236944 A
- JP S6320270 B
- JP H0419720 B